(19) Europäisches Patentamt
European Patent Office
Office européen des brevets

(11) **EP 4 654 327 A1**

(12) **EUROPEAN PATENT APPLICATION**

(43) Date of publication:
26.11.2025 Bulletin 2025/48

(21) Application number: 25176595.4

(22) Date of filing: 15.05.2025

(51) International Patent Classification (IPC):
$H01M\ 10/42^{(2006.01)}$ $\quad G01R\ 31/392^{(2019.01)}$
$H01M\ 10/48^{(2006.01)}$ $\quad H01M\ 4/587^{(2010.01)}$
$H01M\ 10/0525^{(2010.01)}$

(52) Cooperative Patent Classification (CPC):
H01M 10/48; G01R 31/392; H01M 10/4285;
H01M 10/486; H01M 4/587; H01M 10/0525

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 23.05.2024 KR 20240067293

(71) Applicant: SAMSUNG SDI CO., LTD.
Yongin-si, Gyeonggi-do 17084 (KR)

(72) Inventor: KIM, Minsoo
17084 Yongin-Si Gyeonggi-do (KR)

(74) Representative: Gulde & Partner
Patent- und Rechtsanwaltskanzlei mbB
Berliner Freiheit 2
10785 Berlin (DE)

(54) **METHOD AND SYSTEM FOR DETECTING DEFECTIVE CELLS**

(57) A defective cell detection method (800) includes: performing (S810) at least one of a charge or a discharge of a cell (110) so that a state of charge, SOC, of the cell (110) falls within a range; obtaining (S820) first charge/discharge data including voltage and temperature information during the charge and/or discharge of the cell (110); calculating (S830) an entropy value of the cell (110) based on the first charge/discharge data; estimating (S840) a state of a graphite interface of the cell (110) based on the calculated entropy value; and determining (S850) whether or not the cell (110) is defective based on the estimated state of the graphite interface of the cell (110).

FIG. 8

**Description**

**BACKGROUND**

**1. Field**

Aspects of embodiments of the present disclosure relate to a method and a system for detecting defective cells.

**2. Description of the Related Art**

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

Defective secondary batteries may cause various problems such as a fire. In order to detect defects in the secondary battery, the secondary battery may be disassembled, and then a state of the anode of a cell may be confirmed using an electron microscope or the like.

The above information disclosed in this Background section is for enhancement of understanding of the background of the present disclosure, and therefore, it may contain information that does not constitute related (or prior) art.

**SUMMARY**

If a cell of a secondary battery is disassembled in order to diagnose an internal state of the secondary battery, even healthy cells may be discarded when disassembled.

Embodiments of the present disclosure may be directed to a method and a system for detecting defective cells.

These and other aspects and features of the present disclosure will be described in or will be apparent from the following description of embodiments of the present disclosure.

According to one or more embodiments of the present disclosure, a defective cell detection method includes: performing at least one of a charge or a discharge of a cell so that a state of charge (SOC) of the cell falls within a range (e.g., a predetermined range); obtaining first charge/discharge data including voltage and temperature information during the charge and/or the discharge of the cell; calculating an entropy value of the cell based on the first charge/discharge data; estimating a state of a graphite interface of the cell based on the calculated entropy value; and determining whether or not the cell is defective based on the estimated state of the graphite interface of the cell.

In an embodiment, the method may further include: in response to the cell being determined to be defective, outputting information associated with the cell.

In an embodiment, the state of the graphite interface of the cell may indicate an interface deterioration of a graphite anode of the cell.

In an embodiment, the range (e.g., the predetermined range) may be associated with the state of the graphite interface of the cell.

In an embodiment, the range (e.g., the predetermined range) may be a SOC range of 22% to 50%.

In an embodiment, the charge and/or the discharge of the cell may be performed at a constant rate.

In an embodiment, the constant rate may be equal to or greater than a threshold (e.g., a predetermined threshold).

In an embodiment, the estimating may include comparing the calculated entropy value with a reference entropy value to estimate the state of the graphite interface of the cell.

In an embodiment, the reference entropy value may be determined based on entropy values of a plurality of normal cells (e.g., cells that may be determined to be normal or nondefective).

In an embodiment, the cell may have undergone a formation process.

In an embodiment, the method may further include: in response to the cell being determined to be defective, performing a re-formation process on the cell.

In an embodiment, the method may further include: obtaining second charge/discharge data after the re-formation process is performed on the cell; re-estimating the state of the graphite interface of the cell based on the second charge/discharge data; and based on the re-estimated state of the graphite interface, determining whether or not the cell is defective.

In an embodiment, the entropy value may be associated with an arrangement of lithium layers in the cell.

In an embodiment, a non-transitory computer-readable recording medium may store instructions for performing the method on a computer.

According to one or more embodiments of the present disclosure, an apparatus includes: memory; and one or more processors coupled to the memory, and configured to execute instructions stored in the memory (e.g., of one or more computer readable programs included in the memory) to: perform at least one of a charge or a discharge of a cell so that a state of charge of the cell falls within a range (e.g., a predetermined range); obtain first charge/discharge data including voltage and temperature information during the charge and/or discharge of the cell; calculate an entropy value of the cell based on the first charge/discharge data; estimate a state of a graphite interface of the cell based on the calculated entropy value; and determine whether or not the cell is defective based on the estimated state of the graphite interface of the cell.

In an embodiment, the apparatus may further include a communication module.

In an embodiment, the instructions may further cause the one or more processors to: in response to the cell being determined to be defective, output information associated with the cell.

In an embodiment, the range (e.g., the predetermined range) may be associated with the state of the graphite interface of the cell.

In an embodiment, the range (e.g., the predetermined range) may be a SOC range of 22% to 50%.

In an embodiment, the charge and/or discharge of the cell may be performed at a constant rate.

In an embodiment, to estimate, the instructions may further cause the one or more processors to compare the calculated entropy value with a reference entropy value to estimate the state of the graphite interface of the cell.

According to some embodiments of the present disclosure, a defective cell may be detected through an electrochemical analysis without disassembling the cell. Accordingly, users may more easily detect defective cells simply by charging and discharging the cell, and a reliability of defective cell detection may be improved.

According to some embodiments of the present disclosure, defective cells may be detected non-destructively. In addition, according to some embodiments, defective cells may be treated to stabilize a defective graphite interface through a re-formation process, and cells that are not improved by the re-formation process may be treated as defective cells. Accordingly, a reliability of the defective cell detection may be improved.

These and other aspects and features of the present disclosure will be described in or will be apparent from the following description of embodiments of the present disclosure.

However, aspects and features of the present disclosure are not limited to those described above, and other aspects and features not mentioned will be clearly understood by a person skilled in the art from the detailed description, described below.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

**BRIEF DESCRIPTION OF DRAWINGS**

The following drawings attached to this specification illustrate embodiments of the present disclosure, and further describe aspects and features of the present disclosure together with the detailed description of the present disclosure. Thus, the present disclosure should not be construed as being limited to the drawings.

FIG. 1 shows a defective cell detection method according to an embodiment of the present disclosure.

FIG. 2 is a schematic diagram illustrating an information processing system communicably connected to a plurality of user terminals in order to detect a defective cell according to an embodiment of the present disclosure.

FIG. 3 is a block diagram illustrating an internal configuration of a user terminal and the information processing system according to an embodiment of the present disclosure.

FIG. 4 is a diagram illustrating an internal configuration of a processor of the information processing system according to an embodiment of the present disclosure.

FIG. 5 is a diagram illustrating a graph showing a change in an entropy value depending on a rate according to an embodiment of the present disclosure.

FIG. 6 is a diagram illustrating graphs showing changes in entropy values depending on additives according to an embodiment of the present disclosure.

FIG. 7 is a flowchart illustrating a defective cell detection method according to an embodiment of the present disclosure.

FIG. 8 is a flowchart illustrating a method for detecting a defective cell according to an embodiment of the present disclosure.

## DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor may be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that may replace or modify the embodiments described herein at the time of filing this application.

It will be understood that when a layer or element is referred to as being "between" two layers, it may be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of local patent laws.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Further, the term "module" or "part" used herein refers to a software or hardware component, and "module" or "part" performs certain roles. However, the meaning of the "module" or "part" is not limited to software or hardware. The "module" or "part" may be configured to be in an addressable storage medium or configured to play one or more processors. Accordingly, as an example, the "module" or "part" may include components such as software components, object-oriented software components, class components, and task components, and at least one of processes, functions, attributes, procedures, subroutines, program code segments, drivers, firmware, micro-codes, circuits, data, database, data structures, tables, arrays, and variables. Furthermore, functions provided in the components and the "modules" or "parts" may be combined into a smaller number of components and "modules" or "parts", or further divided into additional components and "modules" or "parts."

The "module" or "part" may be implemented as a processor and a memory. The "processor" should be interpreted broadly to encompass a general-purpose processor, a central processing unit (CPU), a microprocessor, a digital signal processor (DSP), a controller, a microcontroller, a state machine, and so forth. Under some circumstances, the "processor" may refer to an application-specific integrated circuit (ASIC), a programmable logic device (PLD), a field-programmable gate array (FPGA), and so on. The "processor" may refer to a combination for processing devices, for example, a combination of a DSP and a microprocessor, a combination of a plurality of microprocessors, a combination of one or more microprocessors in conjunction with a DSP core, or any other combination of such configurations. In addition, the "memory" should be interpreted broadly to encompass any electronic component that is capable of storing electronic information. The "memory" may refer to various types of processor-readable media such as random-access memory (RAM), read-only memory (ROM), non-volatile random-access memory (NVRAM), programmable read-only memory (PROM), erasable programmable read-only memory (EPROM), electrically erasable PROM (EEPROM), flash memory, magnetic or optical data storage, registers, and the like. The memory is said to be in electronic communication with a processor if the processor may read information from and/or write information to the memory. The memory integrated with the processor is in electronic communication with the processor.

In the present disclosure, a "system" may refer to at least one of a server apparatus and a cloud apparatus, but aspects are not limited thereto. For example, the system may include one or more server apparatus. In another example, the system may include one or more cloud apparatus. In still another example, the system may include both the server apparatus and the cloud apparatus operated in conjunction with each other.

In the present disclosure, a "display" may refer to any display device associated with a computing device, e.g., any display device capable of displaying any information/data controlled by or provided by the computing device.

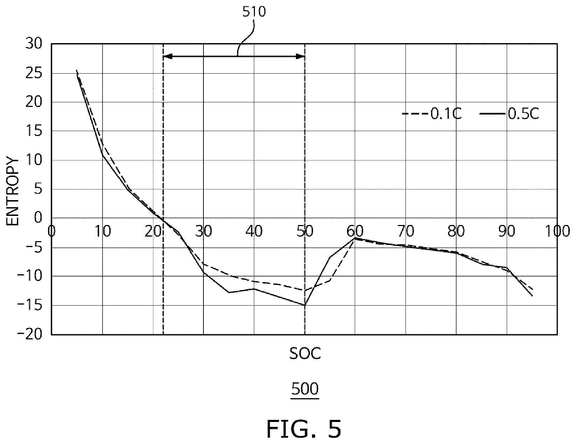

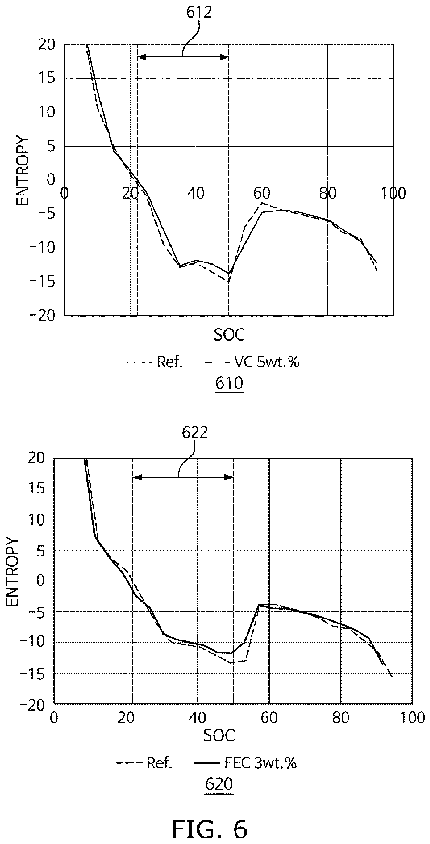

In the present disclosure, an "entropy value" may represent an entropy change value (i.e., Δentropy) calculated based on the voltage change and temperature change of the cell. Likewise, "entropy" shown in FIGS. 5 and 6 may also represent the entropy change value calculated based on the voltage change and temperature change of the cell.

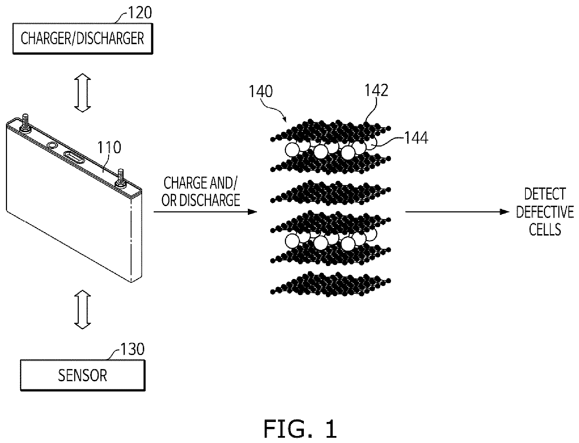

FIG. 1 shows a defective cell detection method according to an embodiment of the present disclosure. In an embodiment, a cell 110 that has undergone a formation process may be connected to a charger/discharger 120 and a sensor 130. In this case, the charger/discharger 120 may charge or discharge the cell 110, so that a state of charge (SOC) of the cell 110 falls within a suitable range (e.g., a predetermined range). The range may be associated with a state of a graphite interface of the cell 110. Additionally, the sensor 130 may measure a voltage and a temperature of the cell 110 during the charging and/or discharging of the cell 110.

In an embodiment, a processor (e.g., at least one processor of an information processing system) may obtain charge/discharge data including voltage information and temperature information during the charging and/or discharging of the cell 110. Additionally, the processor may calculate the entropy value of the cell 110 based on the charge/discharge data.

In an embodiment of the present invention, the entropy value of the cell may be calculated based on voltage and temperature data measured at a specific state of charge (SOC). For example, by measuring the slope of voltage with respect to temperature, the entropy value may be calculated using the following equation 1:

【Equation 1】

$$\Delta S = -\left(\frac{\partial T}{\partial V}\right)_{SOC} \cdot \frac{nF}{T}$$

where $\Delta S$ is the entropy change (J/mol·K), V is the voltage (V), T is the absolute temperature (K), n is the number of electrons, and F is the Faraday constant.

The entropy value may be associated with an arrangement of lithium layers within a graphite anode 140 of the cell 110. In more detail, the graphite anode 140 may include lithium 144 disposed between graphite layers 142. If (e.g., when) the state of the graphite interface where an electrolyte through which the lithium 144 moves and the graphite layer 142 meet each other is poor, the arrangement state of the lithium 144 may be unstable due to a non-uniform surface reaction in a suitable SOC range (e.g., a predetermined SOC range). Accordingly, the entropy value of the cell 110 may increase. The relationship between the entropy value of the cell 110 and the graphite interface state is described in more detail below with reference to FIGS. 5 and 6.

In an embodiment, the processor may estimate the state of the graphite interface of the cell 110 based on the calculated entropy value. The state of the graphite interface may indicate an interface deterioration of the graphite anode 140 of the cell 110. Additionally, the processor may determine whether or not the cell 110 is defective based on the estimated state of the graphite interface of the cell 110. In more detail, the processor may estimate that there is a change in the arrangement of the lithium 144 in the graphite anode 140 by comparing the calculated entropy value and a reference entropy value. In this case, the reference entropy value may be determined based on the entropy values of a plurality of normal cells that are determined to be normal. For example, the reference entropy value is a standard value derived from experimental data obtained from cells in a normal (healthy) state. This value may be determined by collecting data from multiple cell samples within the same state-of-charge (SOC) range and averaging the results under controlled temperature conditions through repeated measurements. Accordingly, the reference entropy value may serve as a criterion for determining whether the cell has any physical abnormalities.

Because the change in the arrangement of the lithium 144 may be due to a difference in lithium insertion, and the difference in lithium insertion may be due to a difference in the graphite interface, the state of the graphite interface of the cell 110 may be estimated based on the entropy value. In other words, if (e.g., when) the graphite interface is non-uniform, the lithium layer arrangement may change, and the entropy value may be different from the reference entropy value.

In an embodiment, the processor may estimate the state of the graphite interface by comparing the calculated entropy value with the reference entropy value. For example, if the entropy deviation is less than or equal to 5%, the processor may estimate that the state of the graphite interface is normal. If the entropy deviation exceeds 5%, the processor may estimate that the state of the graphite interface is abnormal.

If the state of the graphite interface is classified as "abnormal," the cell may be determined to be defective. This determination may be based not only on an absolute comparison of entropy values, but also on a comprehensive evaluation that includes the temporal trend of entropy variation and other electrochemical parameters, such as an increase in internal resistance or voltage delay. Accordingly, the defect determination according to the present invention may not solely based on the calculated entropy value itself, but may be performed based on the estimated state of the graphite interface derived from the entropy value.

In an embodiment, the processor may output information associated with the cell 110 in response to the cell 110 being determined to be defective. The information associated with the cell 110 may include identification information of the cell 110, location information of the cell 110, the temperature information of the cell 110, the voltage information of the cell 110, the entropy value of the cell 110, information to determine whether or not the cell 110 is defective, and information to determine whether or not a re-formation process should be performed, but the present disclosure is not limited thereto. Accordingly, the user may easily identify cells that should be treated as defective cells, cells that should undergo a re-formation process, and the like through the information associated with the cell 110 that is output on a display.

As such, the defective cells may be detected through electrochemical analysis without disassembling the cell. Accordingly, users may more easily detect defective cells simply by charging and discharging the cell, and the reliability of defective cell detection may be improved.

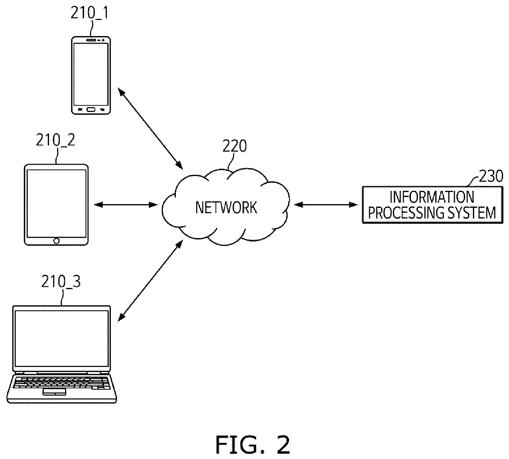

FIG. 2 is a schematic diagram illustrating an information processing system 230 communicably connected to a plurality of user terminals 210_1, 210_2, and 210_3 in order to detect a defective cell according to an embodiment of the present disclosure. Referring to FIG. 2, the plurality of user terminals 210_1, 210_2, and 210_3 may be connected to the information processing system 230 that provides a defective cell determination service through a network 220. The plurality of user terminals 210_1, 210_2, and 210_3 may include a user terminal that receives the defective cell determination service.

In an embodiment, the information processing system 230 may include one or more server apparatuses and/or databases for storing, providing, and executing computer-executable programs (e.g., downloadable applications) and data associated with the defective cell determination service, or may include one or more distributed computing devices and/or distributed databases based on cloud computing services.

The defective cell determination service of the information processing system 230 may be provided to the user through a defective cell determination application, a web browser, a web browser extension program, or the like installed on each of the plurality of user terminals 210_1, 210_2, and 210_3. For example, the information processing system 230 may provide information, or may perform a processing corresponding to a defective cell determination request received from the user terminals 210_1, 210_2, and 210_3 through a defective cell determination application or the like.

The plurality of user terminals 210_1, 210_2, and 210_3 may communicate with the information processing system 230 through the network 220. The network 220 may enable communications between the plurality of user terminals 210_1, 210_2, and 210_3 and the information processing system 230. Depending on an installation environment, the network 220 may include, for example, a wired network such as Ethernet, a wired home network (e.g., a Power Line Communication), a telephone line communication device, an RS-serial communication, a wireless network such as a mobile communication network, a wireless LAN (WLAN), Wi-Fi, Bluetooth, ZigBee, or a suitable combination thereof. However, the present disclosure is not limited thereto, and the network 220 may include various suitable communication methods utilizing various suitable communication networks (e.g., mobile communication networks, wired Internet, wireless Internet, broadcasting networks, satellite networks, and/or the like), as well as short-range wireless communications between the user terminals 210_1, 210_2, and 210_3.

In FIG. 2, a mobile phone terminal 210_1, a tablet terminal 210_2, and a PC terminal 210_3 are illustrated as some representative examples of the user terminals, but the present disclosure is not limited thereto, and the user terminals 210_1, 210_2, and 210_3 may include any suitable computing device on which a defective cell determination application, a web browser, or the like may be installed and executed. For example, the user terminals may include AI speakers, smartphones, mobile phones, navigations, computers, laptops, digital broadcasting terminals, personal digital assistants (PDAs), portable multimedia players (PMPs), tablet PCs, game consoles, wearable devices, Internet Of Things (IoT) devices, virtual reality (VR) devices, augmented reality (AR) devices, set-top boxes, and the like. In addition, in FIG. 2, three user terminals 210_1, 210_2, and 210_3 are illustrated as communicating with the information processing system 230 through the network 220, but the present disclosure is not limited thereto, and a different number of user terminals may be communicably connected to the information processing system 230 through the network 220.

In FIG. 2, a user's request (e.g., a defective cell determination request) may be transmitted to the information processing system 230 through the user terminals 210_1, 210_2, and 210_3, but the present disclosure is not limited thereto. The user's request may be provided to the information processing system 230 through an input device associated with the information processing system 230 without going through the user terminals 210_1, 210_2, and 210_3. Furthermore, a result of the processing of the user's request (e.g., whether or not the cell is defective) may be provided to the user through an output device (e.g., a display or the like) associated with the information processing system 230.

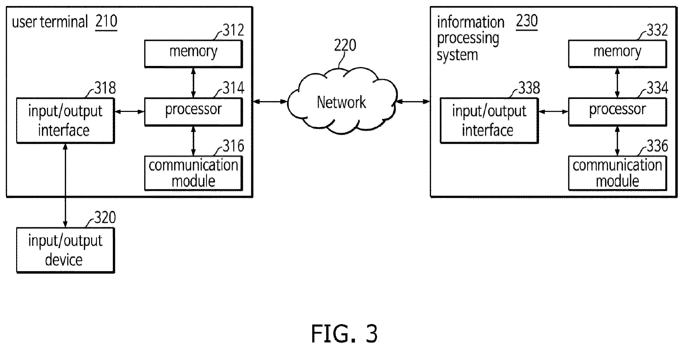

FIG. 3 is a block diagram illustrating an internal configuration of the user terminal 210 and the information processing system 230 according to an embodiment of the present disclosure. The user terminal 210 may refer to any suitable computing device capable of executing applications, web browsers, and the like, and for performing wired/wireless communications, for example. The user terminal 210 may include the mobile phone terminal 210_1, the tablet terminal 210_2, and/or the PC terminal 210_3 described above with reference to FIG. 2, for example. As illustrated in FIG. 3, the user terminal 210 may include a memory 312, a processor 314, a communication module 316, and an input/output interface 318. The information processing system 230 may include a memory 332, a processor 334, a communication module 336, and an input/output interface 338. The user terminal 210 and the information processing system 230 may communicate information and/or data with each other through the network 220 using their respective communication modules 316 and 336. Additionally, an input/output device 320 may input information and/or data to the user terminal 210 through the input/output interface 318, or may output information and/or data generated from the user terminal 210.

The memories 312 and 332 may include any suitable non-transitory computer-readable recording medium. According to an embodiment, the memories 312 and 332 may include permanent mass storage devices, such as read-only memory (ROM), a disk drive, a solid state drive (SSD), flash memory, and/or the like. As another example, permanent mass storage devices, such as ROM, a SSD, flash memory, a disk drive, and/or the like may be included in the user terminal 210 or the information processing system 230 as a separate permanent storage device that is distinct from the memories 312 and 332. Additionally, an operating system and at least one program code may be stored in the memories 312 and 332.

Software components may be loaded from a computer-readable recording medium separate from the memories 312 and 332. The separate computer-readable recording medium may include a recording medium directly connectable to the user terminal 210 and the information processing system 230, and may include a computer-readable recording medium, such as a floppy drive, a disk, a tape, a DVD/CD-ROM drive, or a memory card, for example. As another example, software components may be loaded into the memories 312 and 332 through the communication modules 316 and 336, rather than through the computer-readable recording medium. For example, at least one program may be loaded into the memories 312 and 332 based on a computer program installed by files provided through the network 220 by a developer, or a file distribution system that distributes application installation files.

The processors 314 and 334 may process instructions of a computer program by performing basic arithmetic, logic, and input/output operations. The instructions may be provided to the processors 314 and 334 by the memories 312 and 332 or the communication modules 316 and 336. For example, the processors 314 and 334 may execute received instructions according to program codes stored in a recording device, such as the memories 312 and 332.

The communication modules 316 and 336 may provide components or functions for the user terminal 210 and the information processing system 230 to communicate with each other through the network 220, and may provide components or functions for the user terminal 210 and/or the information processing system 230 to communicate with another user terminal or another system (e.g., a separate cloud system or the like). For example, a request or data (e.g., a defective cell determination request or the like) generated by the processor 314 of the user terminal 210 according to program code stored in a recording device, such as the memory 312, may be transmitted to the information processing system 230 through the network 220 under the control of the communication module 316. Conversely, a control signal or a command provided under the control of the processor 334 of the information processing system 230 may be received by the user terminal 210 through the communication module 316 of the user terminal 210 via the communication module 336 and the network 220.

The input/output interface 318 may interface with the input/output device 320. As an example, the input devices may include cameras including audio sensors and/or image sensors, keyboards, microphones, and/or mouse devices, and the output devices may include displays, speakers, or haptic feedback devices. As another example, the input/output interface 318 may interface with a touch screen in which components or functions for performing input and output are integrated with each other. For example, when the processor 314 of the user terminal 210 executes instructions of a computer program loaded into the memory 312, a service screen or the like using information and/or data provided by the information processing system 230 or another user terminal may be displayed on a display through the input/output interface 318. In FIG. 3, the input/output device 320 is illustrated as not being included in the user terminal 210, but the present disclosure is not limited thereto, and the input/output device 320 and the user terminal 210 may be configured together as a single device. Additionally, the input/output interface 338 of the information processing system 230 may interface with an input/output device that may be connected to the information processing system 230 or included in the information processing system 230. In FIG. 3, the input/output interfaces 318 and 338 are illustrated as elements configured separately from the processors 314 and 334, respectively, but the present disclosure is not limited thereto, and the input/output interfaces 318 and 338 may be included in the processors 314 and 334, respectively.

The user terminal 210 and information processing system 230 may include more components than those illustrated in FIG. 3, and thus, may be variously modified as needed or desired as would be understood by those having ordinary skill in the art. In an embodiment, the user terminal 210 may include at least some of the input/output device 320 described above. Additionally, the user terminal 210 may further include other suitable components, such as a transceiver, a global positioning system (GPS) module, a camera, various suitable sensors, and/or a database.

While a program for a defective cell determination service or the like is running, the processor 314 may receive text, images, videos, voices, and/or motions input or selected through an input device, such as a touch screen, a keyboard, a camera including an audio sensor and/or an image sensor, a microphone, or the like connected to the input/output interface 318, and may store the received text, images, videos, voices, and/or motions in the memory 312 or provide the same to the information processing system 230 through the communication module 316 and the network 220.

The processor 314 of the user terminal 210 may manage, process, and/or store the information and/or the data received from the input/output device 320, other user terminals, the information processing system 230, and/or a plurality of external systems. The information and/or data processed by the processor 314 may be provided to the information processing system 230 through the communication module 316 and the network 220. The processor 314 of the user terminal 210 may transmit and output the information and/or data to the input/output device 320 through the input/output interface 318. For example, the processor 314 may output or display the received information and/or data on the screen of the user terminal 210.

The processor 334 of the information processing system 230 may manage, process, and/or store information and/or data received from a plurality of user terminals 210 and/or a plurality of external systems. The information and/or data processed by the processor 334 may be provided to the user terminal 210 through the communication module 336 and the network 220.

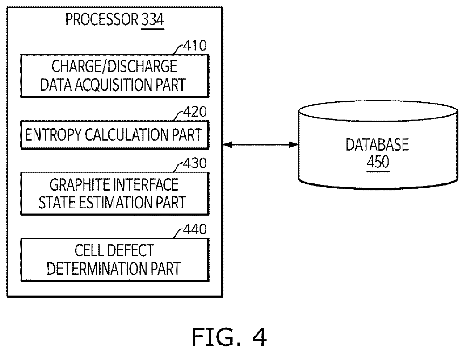

FIG. 4 is a diagram illustrating an internal configuration of the processor 334 of the information processing system according to an embodiment of the present disclosure. As shown in FIG. 4, the processor 334 of the information processing system may include a charge/discharge data acquisition part 410, an entropy calculation part 420, a graphite interface state estimation part 430, and a cell defect determination part 440. In FIG. 4, the information processing system includes a single processor, but the present disclosure is not limited thereto, and the information processing system may include a plurality of processors.

The charge/discharge data acquisition part 410 may acquire first charge/discharge data associated with the cell while charging/discharging the cell. The first charge/discharge data may include cell voltage information, temperature information, and the like. The charge/discharge data acquired by the charge/discharge data acquisition part 410 may be stored in a database 450.

In an embodiment, the charge/discharge data acquisition part 410 may generate a control signal applied to a charger/discharger (e.g., 120 in FIG. 1), and may transmit the control signal to the charger/discharger in order to obtain charge/discharge data. The control signal may be used to control the charge and/or discharge of the charger/discharger, so that the state of a charge of the cell falls within a suitable range (e.g., a predetermined range, such as from 22% to 50%, or the like), or may control the charge or discharge rate of the charger/discharger (e.g., 0.33C, or the like) to be constant or substantially constant. For example, when the state of charge of a cell is 10%, the charge/discharge data acquisition part 410 may generate a signal to control the charge of the charger/discharger, so that the state of charge of the cell becomes 50%, and may transmit the signal to the charger/discharger. As another example, when the state of charge of the cell is 60%, the charge/discharge data acquisition part 410 may generate a signal to control the discharge of the charger/-discharger, so that the state of charge of the control signal cell becomes 22%, and transmit the signal to the charger/-discharger.

The entropy calculation part 420 may calculate the entropy value of the cell based on the charge/discharge data acquired by the charge/discharge data acquisition part 410. In more detail, the entropy calculation part 420 may calculate the entropy value based on the temperature and the voltage in a desired state of charge (e.g., a specific or predetermined state of charge) of the cell. The entropy value may be associated with an arrangement of the lithium layers in the cell. For example, the entropy calculation part 420 may calculate the entropy value in the SOC range of 22% to 50% based on the temperature and the voltage collected during the charge/discharge of the cell in that range. The entropy value calculated by the entropy calculation part 420 may be stored in the database 450.

The graphite interface state estimation part 430 may estimate the state of the graphite interface of the cell based on the entropy value calculated by the entropy calculation part 420. The state of the graphite interface of the cell may indicate an interface degradation of the graphite anode of the cell. In more detail, the graphite interface state estimation part 430 may estimate the state of the graphite interface of the cell by comparing the calculated entropy value and a reference entropy value with each other. In this case, the reference entropy value may be determined based on the entropy values of a plurality of normal cells that are determined to be normal. For example, if (e.g., when) the calculated entropy value differs by more than 1% from the average of the entropy values of a plurality of normal cells, the graphite interface state estimation part 430 may estimate that the state of the graphite interface of the cell is not normal, but the present disclosure is not limited thereto.

The cell defect determination part 440 may determine whether or not the cell is defective based on the state of the graphite interface of the cell estimated by the graphite interface state estimation part 430. If (e.g., when) the cell defect determination part 440 determines that a cell that has already undergone a formation process is defective, it may generate a control signal to perform the re-formation process for the cell, or may output information associated with the cell.

In an embodiment, after the process of re-forming the cell that is determined to be defective, the charge/discharge data acquisition part 410 may acquire second charge/discharge data associated with the cell during the charge/discharge of the cell, so that the state of charge of the cell falls within a suitable range (e.g., a predetermined range). Additionally, the entropy calculation part 420 may recalculate the entropy value of the cell based on the second charge/discharge data. Further, the graphite interface state estimation part 430 may re-estimate the state of the graphite interface of the cell based on the recalculated entropy value. Based on the re-estimated state of the graphite interface, the cell defect determination part 440 may re-determine whether or not the cell is defective. If (e.g., when) the cell defect determination part 440 determines that the cell is defective, the cell may be finally treated as a defective cell.

In an embodiment, the cell defect determination part 440 may output information associated with the cell in response to determining that the cell is defective (e.g., a final defect determination after a re-formation process). The information associated with the cell may be information stored in the database 450, and may include, but is not limited to, cell identification information, cell location information, cell temperature information, cell voltage information, and a cell entropy value.

FIG. 5 is a diagram illustrating a graph 500 showing a change in an entropy value depending on a rate according to an embodiment of the present disclosure. In an embodiment, the entropy value of a cell may be associated with the arrangement of the lithium layers of the cell. In more detail, the graphite anode may include lithium disposed between the graphite interfaces. If (e.g., when) the state of the graphite interface is poor, the lithium layer arrangement may be unstable due to a non-uniform surface reaction in the SOC range (e.g., the predetermined SOC range) 510. The SOC range 510 is associated with the state of the graphite interface of the cell, and may range from 22% to 50%.

The graph 500 shows the change in the entropy value according to a constant rate (C-rate) for charging and discharging the cell. In an embodiment, the amount of lithium present in the lithium layer is small in a SOC section lower than the predetermined SOC range 510 (e.g., an SOC section less than 22%), so the surface reaction may have a lesser effect on the lithium arrangement. Accordingly, in the corresponding section, the difference in entropy values depending on the rate may be relatively small. On the other hand, in a SOC section higher than the predetermined SOC range 510 (e.g., an SOC section exceeding 50%), the amount of lithium present in the lithium layer is large, so the change in the lithium layer arrangement may be minimal. Accordingly, in the corresponding section, the difference in the entropy values depending on the rate may be relatively small.

In an embodiment, the lithium layer spacing is reasonably narrow in the predetermined SOC range 510, so that surface reactions may have a relatively large effect on the lithium arrangement. In an embodiment, when the cell is charged at a low rate (e.g., 0.1C), the surface reaction of lithium may be uniform or substantially uniform, so that the surface reaction may have a lesser effect on the lithium arrangement. On the other hand, when the cell is charged at a high rate (e.g., 0.5C), the surface reaction of lithium may be non-uniform, so that the surface reaction may have a relatively large effect on the lithium arrangement. Accordingly, referring to the graph 500, a change in the rate within the predetermined SOC range 510 results in a different entropy value of the cell. In other words, the entropy value of the cell may be associated with the arrangement of the lithium layers of the cell and the graphite interface state.

In FIG. 5, the SOC range (e.g., the predetermined SOC range) 510 ranges from 22% to 50%, but the present disclosure is not limited thereto. For example, the predetermined SOC range 510 may include a SOC range in which the entropy value of the cell is observed to be different from the reference entropy value.

FIG. 6 is a diagram illustrating graphs 610 and 620 showing changes in entropy values depending on additives according to an embodiment of the present disclosure. In an embodiment, the entropy value of a cell may be associated with the arrangement of the lithium layers of the cell. In more detail, the graphite anode may include lithium disposed between the graphite interfaces.

The first graph 610 shows the change in the entropy value of the cell when vinylene carbonate (VC), a graphite interface modification additive, is added. Additionally, the second graph 620 shows the change in the entropy value of the cell when fluoroethylene carbonate (FEC), a graphite interface modification additive, is added. The graphite interface modification additives form a uniform (or substantially uniform) and robust interface at the graphite interface, and do not change the structure or ionic conductivity of graphite except for the graphite interface. In addition, referring to the SOC range (e.g., the predetermined SOC range) 612 of the first graph 610 and the SOC range (e.g., the predetermined SOC range) 622 of the second graph 620, when the graphite interfacial modification additive is added, the entropy value of the cell may be different from the reference entropy value (Ref.). In other words, the entropy value of the cell may be associated with the graphite interface state.

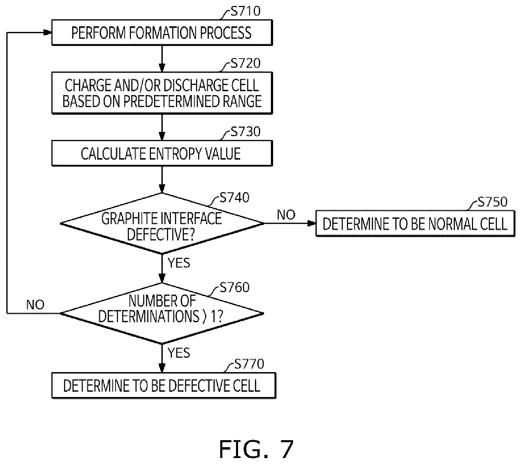

FIG. 7 is a flowchart illustrating a defective cell detection method according to an embodiment of the present disclosure. In an embodiment, the method for detecting a defective cell may start, and a formation process may be performed on a cell (S710), for example, using formation process equipment. At least one of the charge or discharge of the cell may be performed based on a state of charge range (e.g., a predetermined state of charge range) of the cell (e.g., SOCs of 22% to 50%) (S720). In this case, the charge or discharge of the cell may be performed at a constant or substantially constant rate (e.g., 0.33C). The processor (e.g., 334 in FIG. 3) may obtain first charge/discharge data including voltage and temperature information during the charge/discharge of the cell.

The processor may calculate the entropy value of the cell based on the first charge/discharge data (S730). Additionally, the processor may determine whether or not the graphite interface of the cell is defective based on the entropy value of the cell (S740). In more detail, the processor may determine whether or not the graphite interface of the cell is defective by comparing the calculated entropy value and the reference entropy value with each other. For example, if (e.g., when) the calculated entropy value differs from the reference entropy value by 1% or more, the processor may determine that the graphite interface of the cell is defective (e.g., YES at S740). If (e.g., when) it is determined that the graphite interface is not defective (e.g., NO at S740), the processor may determine that the cell to be a normal cell (S750). In this case, information indicating that the corresponding cell is a normal cell may be output on the display.

If (e.g., when) it is determined that the graphite interface is defective (e.g., YES at S740), the processor may determine whether the number of times it has determined whether or not the graphite interface of the corresponding cell is defective is two or more times (S760). If (e.g., when) the number of times it has determined whether or not the graphite interface of the cell is defective is one (e.g., NO at S760), a re-formation process on the cell may be performed to stabilize the defective graphite interface (S710). For example, the re-formation process may be performed using the formation process equipment. Thereafter, as described above, the cell that has undergone the re-formation process may be charged and discharged based on a suitable range (e.g., a predetermined range). Additionally, the processor may obtain second charge/discharge data for the cell, and may recalculate the entropy value based on this (S730). Additionally, the processor may re-determine whether or not the graphite interface of the cell is defective based on the second charge/discharge data (S740).

If (e.g., when) the graphite interface of the cell is still defective (e.g., YES at S760), the processor may determine the cell to be a defective cell (S770) because the number of determinations is two. The processor may output information associated with the cell in response to the cell being determined to be defective (e.g., a final defect determination). The information associated with the cell may include, but is not limited to, cell identification information, cell location information, cell temperature information, cell voltage information, and a cell entropy value.

As such, defective cells may be detected non-destructively. In addition, defective cells may be treated to stabilize the defective graphite interface through a re-formation process, and cells that are not improved by the re-formation process may be treated as the defective cells. Accordingly, the reliability of the defective cell detection may be improved.

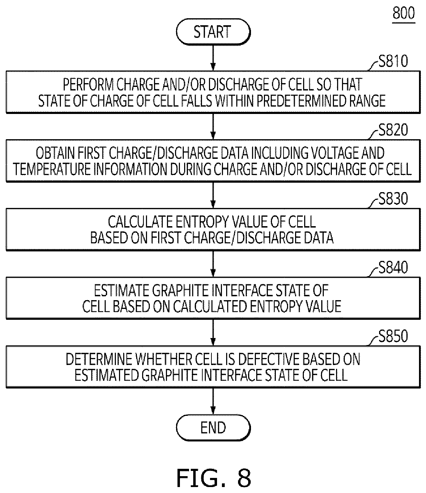

FIG. 8 is a flowchart illustrating a method 800 for detecting a defective cell according to an embodiment of the present disclosure. In an embodiment, the method 800 may be performed by at least one processor. The method 800 may start, and the processor may perform at least one of the charge or discharge of the cell so that the state of charge (SOC) of the cell falls within a range (e.g., a predetermined range) (S810). The predetermined range may be associated with the state of the graphite interface of the cell. For example, the predetermined range may be a SOC range of 22% to 50%.

The processor may obtain first charge/discharge data including voltage and temperature information during the charge/discharge of the cell (S820). Additionally, the processor may calculate the entropy value of the cell based on the first charge/discharge data (S830). The entropy value may be associated with the arrangement of the lithium layers in the cell.

The processor may estimate the state of the graphite interface of the cell based on the calculated entropy value (S840). The state of the graphite interface of the cell may indicate an interface degradation of the graphite anode of the cell. In more detail, the processor may estimate the state of the graphite interface of the cell by comparing the calculated entropy value with the reference entropy value. In this case, the reference entropy value may be determined based on the entropy values of a plurality of normal cells that are determined to be normal.

Additionally, the processor may determine whether or not the cell is defective based on the estimated state of the graphite interface of the cell (S850). In response to the cell being determined to be defective, the processor may output information associated with the cell. For example, information associated with the cell may include cell identification information, a cell entropy value, cell voltage information, cell temperature information, and the like.

In an embodiment, the charge and/or discharge of the cell may be performed at a constant or substantially constant rate (C-rate). The constant rate may be above a threshold (e.g., a predetermined threshold, such as 0.33C, or the like).

In an embodiment, the cell may have undergone a formation process. In this case, in response to the cell being determined to be defective, the processor may perform a re-formation process on the cell. Additionally, the processor may obtain second charge/discharge data after the re-formation process is performed on the cell. Based on the second charge/discharge data, the processor may re-estimate the state of the graphite interface of the cell. Additionally, based on the re-estimated state of the graphite interface, the processor may determine whether or not the cell is defective.

The methods described above may be provided as a computer program stored in a computer-readable recording medium for execution on a computer. The medium may be a kind of medium that continuously stores a program executable by a computer, or temporarily stores the program for execution or download. In addition, the medium may be a variety of writing means or storage means having a single piece of hardware or a combination of several pieces of hardware, and is not limited to a medium that is directly connected to any computer system, and accordingly, may be present on a network in a distributed manner. An example of the medium includes a medium configured to store program instructions, including a magnetic medium such as a hard disk, a floppy disk, and a magnetic tape, an optical medium such as a CD-ROM and a DVD, a magnetic-optical medium such as a floptical disk, and a ROM, a RAM, a flash memory, and the like. In addition, other examples of the medium may include an app store that distributes applications, a site that supplies or distributes various pieces of software, and a recording medium or a storage medium managed by a server.

The methods, operations, or techniques described above may be implemented by various suitable means. For example, these techniques may be implemented in hardware, firmware, software, or a combination thereof. Those skilled in the art will further appreciate that various illustrative logical blocks, modules, circuits, and algorithm steps described in connection with the disclosure herein may be implemented in electronic hardware, computer software, or combinations of both. To clearly illustrate this interchangeability of hardware and software, various illustrative components, blocks, modules, circuits, and steps have been described above generally in terms of their functionality. Whether such a function is implemented as hardware or software varies according to design requirements imposed on the particular application and the overall system. Those skilled in the art may implement the described functions in varying ways for each particular application, but such implementation should not be interpreted as causing a departure from the scope of the present disclosure as defined by the appended claims.

In a hardware implementation, processing units used to perform the techniques may be implemented in one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, computer, or a combination thereof.

Accordingly, various example logic blocks, modules, and circuits described in connection with the present disclosure may be implemented or performed with general purpose processors, DSPs, ASICs, FPGAs or other programmable logic devices, discrete gate or transistor logic, discrete hardware components, or any combination of those designed to perform the functions described herein. The general purpose processor may be a microprocessor, but in the alternative, the processor may be any related processor, controller, microcontroller, or state machine. The processor may also be implemented as a combination of computing devices, for example, a DSP and microprocessor, a plurality of microprocessors, one or more microprocessors associated with a DSP core, or any other combination of the configurations.

In the implementation using firmware and/or software, the techniques may be implemented with instructions stored on a computer-readable medium, such as random-access memory (RAM), read-only memory (ROM), non-volatile random-access memory (NVRAM), programmable read-only memory (PROM), erasable programmable read-only memory (EPROM), electrically erasable PROM (EEPROM), flash memory, compact disc (CD), magnetic or optical data storage devices, and the like. The instructions may be executable by one or more processors, and may cause the processor(s) to perform certain aspects of the functions described in the present disclosure.

If implemented in software, the functions may be stored on or transmitted over as one or more instructions or code on a computer-readable medium. Computer-readable media includes both computer storage media and communication media including any medium that facilitates transfer of a computer program from one place to another. A storage media may be any available media that may be accessed by a general purpose or special purpose computer. By way of example, and not limitation, such computer-readable media may comprise RAM, ROM, EEPROM, CD-ROM or other optical disk storage, magnetic disk storage or other magnetic storage devices, or any other medium that may be used to carry or store desired program code means in the form of instructions or data structures and that may be accessed by a general-purpose or special-purpose computer, or a general-purpose or special-purpose processor. Also, any connection is properly termed a computer-readable medium.

For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and blu-ray disc where disks usually reproduce data magnetically, while discs reproduce data optically with lasers. Combinations of the above should also be included within the scope of computer-readable media.

A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor may read information from, and/or write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

Although the examples described above have been described as utilizing aspects of the currently disclosed subject matter in one or more standalone computer systems, aspects are not limited thereto, and may be implemented in conjunction with any computing environment, such as a network or distributed computing environment. Furthermore, the aspects of the subject matter in the present disclosure may be implemented in multiple processing chips or apparatus, and storage may be similarly influenced across a plurality of apparatus. Such apparatus may include PCs, network servers, and portable apparatus.

Although the present disclosure has been described above with respect to embodiments thereof, the present disclosure is not limited thereto. Various modifications and variations may be made thereto by those skilled in the art within the spirit of the present disclosure and the equivalent scope of the appended claims.

**DESCRIPTION OF SOME REFERENCE SYMBOLS**

110: Cell
120: Charger/discharger
130: Sensor
140: Graphite anode
142: Graphite layer
144: Lithium

**Claims**

**1.** A defective cell detection method (800) comprising:

performing (S810) at least one of a charge or a discharge of a cell (110) so that a state of charge, SOC, of the cell (110) falls within a range;

obtaining (S820) first charge/discharge data including voltage and temperature information during the charge and/or discharge of the cell (110);

calculating (S830) an entropy value of the cell (110) based on the first charge/discharge data;

estimating (S840) a state of a graphite interface of the cell (110) based on the calculated entropy value; and

determining (S850) whether or not the cell (110) is defective based on the estimated state of the graphite interface of the cell (110).

2. The method (800) as claimed in claim 1, further comprising:
in response to the cell (110) being determined to be defective, outputting information associated with the cell (110).

3. The method (800) as claimed in claim 1 or 2, wherein the state of the graphite interface of the cell (110) indicates an interface deterioration of a graphite anode (140) of the cell (110).

4. The method (800) as claimed in any one of the preceding claims, wherein the range is associated with the state of the graphite interface of the cell (110).

5. The method (800) as claimed in any one of the preceding claims, wherein the range is a SOC range (510) of 22% to 50%.

6. The method (800) as claimed in any one of the preceding claims, wherein the charge and/or discharge of the cell (110) is performed at a constant rate.

7. The method (800) as claimed in claim 6, wherein the constant rate is equal to or greater than a threshold.

8. The method (800) as claimed in any one of the preceding claims, wherein the estimating (S840) comprises comparing the calculated entropy value with a reference entropy value to estimate the state of the graphite interface of the cell (110).

9. The method (800) as claimed in claim 8, wherein the reference entropy value is determined based on entropy values of a plurality of normal cells.

10. The method (800) as claimed in any one of the preceding claims, wherein the cell (110) has undergone a formation process.

11. The method (800) as claimed in claim 10, further comprising:
in response to the cell (110) being determined to be defective, performing a re-formation process on the cell (110).

12. The method (800) as claimed in claim 11, further comprising:

obtaining second charge/discharge data after the re-formation process is performed on the cell (110);

re-estimating the state of the graphite interface of the cell (110) based on the second charge/discharge data; and

based on the re-estimated state of the graphite interface, determining whether or not the cell (110) is defective.

13. The method (800) as claimed in any one of the preceding claims, wherein the entropy value is associated with an arrangement of lithium (144) layers in the cell (110).

14. An apparatus, comprising:

memory (312, 332); and

one or more processors (314, 334) coupled to the memory (312, 332), and configured to execute instructions stored in the memory (312, 332) to:

perform at least one of a charge or a discharge of a cell (110) so that a state of charge of the cell (110) falls within a range;

obtain first charge/discharge data including voltage and temperature information during the charge and/or discharge of the cell (110);

calculate an entropy value of the cell (110) based on the first charge/discharge data;
estimate a state of a graphite interface of the cell (110) based on the calculated entropy value; and
determine whether or not the cell (110)is defective based on the estimated state of the graphite interface of the cell (110).

15. The apparatus as claimed in claim 14, wherein the instructions further cause the one or more processors (314, 334) to:
in response to the cell (110) being determined to be defective, output information associated with the cell (110).

FIG. 1

210_1

210_2

210_3

220

NETWORK

230

INFORMATION PROCESSING SYSTEM

FIG. 2

FIG. 3

PROCESSOR 334

410
CHARGE/DISCHARGE
DATA ACQUISITION PART

420
ENTROPY CALCULATION PART

430
GRAPHITE INTERFACE
STATE ESTIMATION PART

440
CELL DEFECT
DETERMINATION PART

DATABASE
450

FIG. 4

FIG. 5

612

ENTROPY

SOC

---- Ref.    —— VC 5wt.%

610

622

ENTROPY

SOC

--- Ref.    —— FEC 3wt.%

620

FIG. 6

S710
PERFORM FORMATION PROCESS

S720
CHARGE AND/OR DISCHARGE CELL
BASED ON PREDETERMINED RANGE

S730
CALCULATE ENTROPY VALUE

S740
GRAPHITE INTERFACE
DEFECTIVE? —— NO —→ DETERMINE TO BE NORMAL CELL   S750

YES

S760
NO ←—— NUMBER OF
DETERMINATIONS ) 1?

YES

S770
DETERMINE TO BE DEFECTIVE CELL

# FIG. 7

EP 4 654 327 A1

800

START

┌─────────────────────────────────────────────┐ S810
│ PERFORM CHARGE AND/OR DISCHARGE OF CELL SO THAT│
│ STATE OF CHARGE OF CELL FALLS WITHIN PREDETERMINED RANGE│
└─────────────────────────────────────────────┘

┌─────────────────────────────────────────────┐ S820
│ OBTAIN FIRST CHARGE/DISCHARGE DATA INCLUDING VOLTAGE AND│
│ TEMPERATURE INFORMATION DURING CHARGE AND/OR DISCHARGE OF CELL│
└─────────────────────────────────────────────┘

┌─────────────────────────────────────────────┐ S830
│ CALCULATE ENTROPY VALUE OF CELL│
│ BASED ON FIRST CHARGE/DISCHARGE DATA│
└─────────────────────────────────────────────┘

┌─────────────────────────────────────────────┐ S840
│ ESTIMATE GRAPHITE INTERFACE STATE OF│
│ CELL BASED ON CALCULATED ENTROPY VALUE│
└─────────────────────────────────────────────┘

┌─────────────────────────────────────────────┐ S850
│ DETERMINE WHETHER CELL IS DEFECTIVE BASED ON│
│ ESTIMATED GRAPHITE INTERFACE STATE OF CELL│
└─────────────────────────────────────────────┘

END

FIG. 8

22

Europäisches
Patentamt

European
Patent Office

Office européen
des brevets

# EUROPEAN SEARCH REPORT

**Application Number**

EP 25 17 6595

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/322488 A1 (YAZAMI RACHID [SG] ET AL) 5 December 2013 (2013-12-05)<br>* figures 17-40 *<br>* example 4 *<br>* claims 1,95 *<br>----- | 1-15 | INV.<br>H01M10/42<br>G01R31/392<br>H01M10/48<br><br>ADD.<br>H01M4/587<br>H01M10/0525 |
| A | US 7 595 611 B2 (CALIFORNIA INST OF TECHN [US]; CENTRE NAT RECH SCIENT [FR]) 29 September 2009 (2009-09-29)<br>* figures 6-31 *<br>* column 14, lines 28-51 *<br>* example 1 *<br>* claims 28,34-36 *<br>----- | 1-15 | |

TECHNICAL FIELDS
SEARCHED      (IPC)

H01M
G01R

The present search report has been drawn up for all claims

| Place of search | Date of completion of the search | Examiner |
|---|---|---|
| The Hague | 23 September 2025 | Knoflacher, Andreas |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

 

& : member of the same patent family, corresponding
      document

EPO FORM 1503 03.82 (P04C01)

## ANNEX TO THE EUROPEAN SEARCH REPORT
## ON EUROPEAN PATENT APPLICATION NO.

EP 25 17 6595

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2025

| Patent document cited in search report | | Publication date | Patent family member(s) | | Publication date |
|---|---|---|---|---|---|
| US 2013322488 A1 | | 05-12-2013 | CN | 104471415 A | 25-03-2015 |
| | | | EP | 2841956 A2 | 04-03-2015 |
| | | | JP | 6368707 B2 | 01-08-2018 |
| | | | JP | 2015522899 A | 06-08-2015 |
| | | | SG | 11201406940Y A | 27-11-2014 |
| | | | US | 2013322488 A1 | 05-12-2013 |
| | | | WO | 2014021957 A2 | 06-02-2014 |
| US 7595611 B2 | | 29-09-2009 | CN | 101365941 A | 11-02-2009 |
| | | | CN | 102569919 A | 11-07-2012 |
| | | | EP | 1924849 A2 | 28-05-2008 |
| | | | JP | 5368091 B2 | 18-12-2013 |
| | | | JP | 5690802 B2 | 25-03-2015 |
| | | | JP | 2009506483 A | 12-02-2009 |
| | | | JP | 2013069695 A | 18-04-2013 |
| | | | US | 2007182418 A1 | 09-08-2007 |
| | | | WO | 2007117263 A2 | 18-10-2007 |

EPO FORM P0459

For more details about this annex : see Official Journal of the European Patent Office, No. 12/82